## Europäisches Patentamt
## European Patent Office
## Office européen des brevets

(19)

(11) Veröffentlichungsnummer: **0 429 133 A2**

# (12) EUROPÄISCHE PATENTANMELDUNG

(21) Anmeldenummer: **90203030.3**

(22) Anmeldetag: **15.11.90**

(51) Int. Cl.5: **H03K 5/04**

(30) Priorität: **20.11.89 DE 3938459**

(43) Veröffentlichungstag der Anmeldung:
**29.05.91 Patentblatt 91/22**

(84) Benannte Vertragsstaaten:
**DE FR GB**

(71) Anmelder: **Philips Patentverwaltung GmbH**
**Wendenstrasse 35 Postfach 10 51 49**
**W-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB**

(72) Erfinder: **Behrens, Michael, Dr.**
**Dientzenhoferstrasse 90**
**W-8500 Nürnberg 30(DE)**

(74) Vertreter: **Peuckert, Hermann, Dipl.-Ing. et al**
**Philips Patentverwaltung GmbH**
**Wendenstrasse 35 Postfach 10 51 49**
**W-2000 Hamburg 1(DE)**

(54) Schaltungsanordnung zur Kompensation von Impulslängenveränderungen.

(57) Es wird eine Schaltungsanordnung zur Kompensation vom Impulslängenveränderungen in einem binären Signal beschrieben. Diese Impulslängenveränderungen sind die Folge von parasitären Reaktanzen im Signalpfad des binären Signals. Eine für integrierte Schaltungen wegen ihrer Einfachheit besonders geeignete Kompensationsschaltung besteht darin, daß das Signal nach Durchlaufen des Signalpfades durch einen Eingangsinverter (I1) invertiert wird, sodann eine Nachbildung (NA) des Signalpfades durchläuft und anschließend durch einen Ausgangsinverter (I1) nochmals invertiert wird. Werden Signalpfad und Nachbildung auf einem gemeinsamen Chip integriert, so entfällt der Abgleich der Nachbildung (NA). Besonders vorteilhaft - weil kostensparend - erweist sich die Anwendung der dargestellten Lehre auf Koppelfeldern, die als integrierte Schaltung realisiert sind. Pro Ausgang des Koppelfeldes ist dann nur eine einzige Nachbildung (NA) erforderlich.

EP 0 429 133 A2

## SCHALTUNGSANORDNUNG ZUR KOMPENSATION VON IMPULSLÄNGENVERÄNDERUNGEN

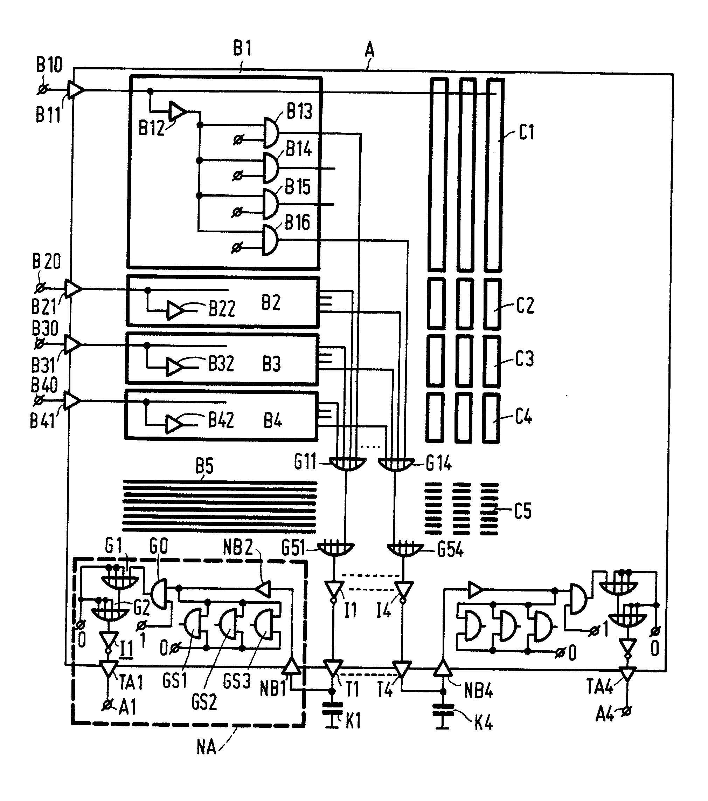

Die Erfindung betrifft eine Schaltungsanordnung zur Kompensation von Impulslängenveränderungen in einem binären Signal, die die Folge von parasitären Reaktanzen in einem Signalpfad sind. Schaltungsanordnungen zur Kompensation von Impulsverzerrungen - also auch Impulslängenveränderungen - in analoger Technik sind bekannt (vergleiche zum Beispiel das Lehrbuch von Steinbuch und Rupprecht: Nachrichtentechnik, Springer-Verlag Berlin/Heidelberg/New York, (1967), Seiten 113 bis 118). Will man jedoch die Impulsverzerrungen kompensieren, die zum Beispiel auf Signalpfaden in integrierten Schaltungen entstehen, so fallen analoge Techniken wegen ihrer räumlichen Dimensionen aus. Denkbar ist, bei integrierten Schaltungen die übliche Impulsregeneration mit Wiederabtastung vorzunehmen (vgl. hierzu die EP O 160 826 B1). Eine andere Möglichkeit wäre die, das Problem durch Verwendung einer schnelleren Technologie zu umgehen, wie zum Beispiel der EP O 148 395 zu entnehmen ist, nach der integrierte Breitbandkoppelfelder in ECL-Technologie ausgeführt sind. Der Erfindung liegt die Aufgabe zugrunde, eine Kompensationsschaltung für den eingangs genannten Zweck anzugeben, die sich wegen ihrer Einfachheit besonders für integrierte Schaltungen eignet. Diese Aufgabe wird dadurch gelöst, daß das Signal nach Durchlaufen des Signalpfades durch einen Eingangsinverter invertiert wird, sodann eine Nachbildung des Signalpfades durchläuft und anschließend durch einen Ausgangsinverter nochmals invertiert wird. Bei der heutigen hochentwickelten Technik, Schaltungen zu integrieren, ist es in vielen Fällen kein erheblicher Aufwand, zusätzlich eine Nachbildung des Signalpfades als integrierte Schaltung herzuestellen. Der erfindungsgemäßen Lehre liegt die Erkenntnis zugrunde, daß ein durch einen Signalpfad zum Beispiel verkürzter Impuls nahezu um den gleichen Betrag verlängert wird, wenn er invertiert wird, den gleichen Signalweg oder dessen Nachbildung nocheinmal durchläuft und nochmals invertiert wird. Werden Signalpfad und dessen Nachbildung auf einem Chip integriert, so entfällt der Abgleich der Nachbildung, denn bekanntlich haben gleiche auf einem Chip integrierte Bauteile auch gleiche elektrische Eigenschaften. Handelt es sich bei der integrierten Schaltung um ein Koppelfeld, so erweist sich die Anwendung der erfindungsgemäßen Lehre als besonders kostengünstig, da alle möglichen Signalpfade durch das Koppelfeld die gleichen parasitären Reaktanzen haben, und daher die Kompensation von Impulslängenveränderungen für alle diese Pfade nur durch eine einzige Nachbildung vorgenommen werden kann. Anhand eines Ausführungsbeispiels und der Figur soll die Erfindung näher erläutert werden. Die Figur zeigt das Prinzipschaltbild eines Koppelfeldes einschließlich erfindungsgemäßer Kompensationsschaltungen. Das Koppelfeld auf der integrierten Schaltung A hat sechzehn Eingänge und ebensoviele Ausgänge; jeder Eingang kann über Gatter mit jedem Ausgang verbunden werden. In der Figur sind nur vier der Eingänge, nämlich B10, B20, B30 und B40 sowie zwei der Ausgänge, nämlich A1 und A4, eingetragen. Die stark umrandeten Teile B1, B2, B3, B4, C1, C2, C3 und C4 sowie deren Andeutungen B5 und C5 sind Teile der integrierten Schaltung A, die den gleichen Aufbau haben wie der Schaltungsteil B1. Der Schaltungsteil B1 besteht aus einem Treiber B12, dessen Ausgang mit dem einen Eingang von vier UND-Gattern B13, B14, B15 und B16 verbunden ist. An den anderen Eingang der UND-Gatter werden Steuersignale gelegt, die die Gatter öffnen oder schließen. Bei den Schaltungsteilen B2, B3 und B4 sind nur die dem Treiber B12 entsprechenden Treiber B22, B32 und B42 gezeigt. Unmittelbar auf die Eingänge B10, B20 usw. folgen auf der integrierten Schaltung Eingangstreiber B11, B21, B31, B41 usw.. Jeder Ausgang der UND-Gatter B13, B14, B15 und B16 ist auf einen Eingang eines von vier ODER-Gattern G11 bis G14 geführt; jedes dieser ODER-Gattern hat noch drei weitere Eingänge, die mit UND-Gatter-Ausgängen der Einheiten B2, B3 und B4 verbunden sind. Die mit dem Schaltungsteil B1 identischen zwölf Schaltungsteile B5 sind durch je vier - nicht gezeigte - ODER-Gatter in der gleichen Weise zusammengefaßt wie die Teile B10, B20, B30 und B40 durch die vier Gatter G11 bis G14. Insgesamt enthält die Schaltung also sechzehn den ODER-Gattern G11 bis G14 ensprechende ODER-Gatter, die die geschilderte Verknüpfung der Bauteile B1, B2, B3, B4 und B5 bewirken. Die Ausgänge dieser sechzehn ODER-Gatter sind wiederum an einen Eingang von vier weiteren ODER-Gattern G51 bis G54 mit jeweils vier Eingängen geführt. Das Ausgangssignal der Gatter G51 bis G54 wird durch In verter I1 bis I4 invertiert und über weitere Treiber T1 bis T4 jeweils an einen nicht näher bezeichneten Ausgangsanschluß gegeben. An diesem Ausgangsanschluß liegt das Signal, das an einen der Eingänge B10, B20 usw. gegeben wird, mit invertierten und verkürzten Impulsen an. Dieses invertierte Signal wird sodann über eine Nachbildung NA des bisher durchlaufenen Signalpfades gegeben. Im vorliegenden Fall erleichtert sich die Nachbildung des Signalweges deshalb, weil alle Signalwege, die von einem der Eingänge B10, B20 usw. zum Beispiel auf den Ausgang des Treibers T1 führen, von ihren

3

elektrischen Eigenschaften her gleich sind. Daher ist pro Treiber T1 bis T4 nur eine Nachbildung NA erforderlich. Sie besteht aus einem Eingangstreiber NB1, der eine Nachbildung der Treiber B11, B21, B31 oder B41 usw. ist, sowie einem weiteren Treiber NB2, durch den einer der Treiber B12, B22, B23, B42 usw. nachgebildet wird. Durch das Gatter GO wird ein durchgeschaltetes UND-Gatter der Teile B1, B2, B3, B4 oder B5 nachgebildet; daher ist einer seiner Eingänge mit dem Ausgang des Treibers NB2 verbunden und an den anderen Eingang eine binäre Eins angelegt. Am Signaleingang des Gatters GO sind drei gesperrte Gatter GS1, GS2 und GS3 angeschlossen, durch die die gesperrten Gatter zum Beispiel der Einheiten B1 oder B2 nachgebildet werden. Die Kaskade zweier ODER-Gatter mit vier Eingängen im Signalweg wird durch die Gatter G1 und G2 nachgebildet, von denen jeweils drei Eingänge auf das Potential einer binären Null gelegt sind. Der Ausgang des Gatters G2 führt auf eine Nachbildung I1 des Inverters I1 und danach folgt die Nachbildung TA1 des Treibers T1. Das Eingangssignal, das von einem der Eingänge B10 bis B40 den beschriebenen Weg durchläuft, ist zweimal invertiert worden und liegt mit nahezu unverzerrten Impulsen am Ausgang A1 an. Voraussetzung ist jedoch, daß die Verkürzung der Impulse auf dem Signalweg nicht einer Unterdrückung gleichkommt. Ein Kondensator K1 am Ausgang des Treibers T1 bildet die kapazitive Last nach, die eine mögliche Anschlußleitung vom Ausgang A1 an eine nächste Koppelfeldstufe haben könnte. Auf dem in der Figur dargestellten Chip kommt die Nachbildung NA insgesamt sechzehn Mal vor. Andeutungsweise ist eine zweite Nachbildung mit einem Kondensator K4, mit Treibern NB4 und TA4 und einem Anschluß A4 gezeigt. Die Nachbildungen sind auf dem gleichen Chip integriert wie der Signalpfad. Daher hat - wie oben schon erwähnt -die Nachbildung NA nahezu die gleichen elektrischen Eigenschaften wie einer der möglichen Signalwege auf dem Chip. Ein Abgleich ist daher - ausgenommen für die Kondensatoren K1,...K4 usw. - nicht erforderlich.

**Ansprüche**

1. Schaltungsanordnung zur Kompensation von Impulslängenveränderungen in einem binären Signal, die die Folge von parasitären Reaktanzen in einem Signalpfad sind,
dadurch gekennzeichnet,
daß das Signal nach Durchlaufen des Signalpfades durch einen Eingangsinverter (I1) invertiert wird, sodann eine Nachbildung (NA) des Signalpfades durchläuft und anschließend durch einen Ausgangsinverter (I1) nochmals invertiert wird. 2. Schaltungsanordnung nach Anspruch 1,

dadurch gekennzeichnet,
daß der Signalpfad, dessen Nachbildung (NA) sowie die Inverter (I1, I1) auf einem gemeinsamen Chip integriert sind. 3. Schaltungsanordnung nach Anspruch 2,
dadurch gekennzeichnet,
daß die Verbindung von Eingangsinverter (I1) und Eingang der Nachbildung (NA) einen Anschluß des Chips enthält, der über einen Kondensator (K1) an Bezugspotential geführt ist. 4. Schaltungsanordnung nach Anspruch 2 oder 3,
dadurch gekennzeichnet,
daß es sich bei der integrierten Schaltung um ein Koppelfeld handelt und pro Ausgang des Koppelfeldes eine Nachbildung (NA) vorgesehen ist.

PHD 89-207